# EUROPÄISCHE PATENTSCHRIFT

(11) **EP 2 367 253 B1**
(45) Veröffentlichungstag und Bekanntmachung des Hinweises auf die Patenterteilung: **11.04.2018**
(21) Anmeldenummer: 11000852.1
(22) Anmeldetag: 03.02.2011
(51) Int. Cl.: H02J 3/38, H01L 31/02

(54) **Photovoltaikfelder, teilweise mit Schalter zum Kurzschließen von Modulen**
Photovoltaic fields, some with switches to bypass modules
Champs photovoltaïques partiellement dotés d'un interrupteur pour court-circuiter les modules

(30) Priorität: 24.02.2010 DE 102010009120
(43) Veröffentlichungstag der Anmeldung: 21.09.2011
(73) Patentinhaber: Adensis GmbH, 01129 Dresden (DE)
(72) Erfinder: Beck, Bernhard, 97332 Volkach OT Dimbach (DE)
(74) Vertreter: Bauer, Daniel

(56) Entgegenhaltungen:
- DE-A1- 3 041 078
- DE-A1-102006 060 815
- US-A1- 2008 147 335

## Beschreibung

Die Erfindung betrifft einen Photovoltaikgenerator mit einer Vielzahl von parallel geschalteten Feldern, wobei jedes Feld aus mehreren parallel geschalteten Strängen (S) von in Reihe geschalteten Photovoltaikmodulen (M) besteht.

Solche Photovoltaikanlagen sind sattsam bekannt. In der Regel sind diese Anlagen so aufgebaut, dass eine Vielzahl von Strängen parallel geschaltet wird. Die maximale Anzahl der Stränge richtet sich dabei nach der Leistung des Wechselrichters, an den die Stränge angeschlossen sind. Moderne Wechselrichter können bis zu einer Eingangsgleichspannung von ca. 900 Volt ausgelegt sein. Zurzeit ist es üblich, jeden Strang der Anlage aus acht Photovoltaikmodulen aufzubauen, von denen jedes 60 Photovoltaikzellen aufweist. Insgesamt sind somit 480 Zellen in Reihe zueinander geschaltet. An jeder Zelle liegt im Leerlauffall eine Spannung von 1,5 Volt an, was zu einer Strangspannung von 720 Volt führt, was deutlich unter der von den Herstellern der Module angegebenen Maximalspannung von 1000 Volt liegt. Liegt eine höhere Spannung an, kann dies zur Zerstörung der Module und der gesamten Anlage führen.

Im Betrieb der Anlage sinkt die Leerlaufspannung der Zellen auf eine Betriebsspannung von ca. 1 bis 1,1 Volt, so dass zwischen den Enden der herkömmlichen Stränge eine Spannung zwischen 480 Volt und 510 Volt anliegt. Im Beispiel der später folgenden Figuren wird der Übersichtlichkeit halber von 1 Volt Betriebsspannung pro Zelle ausgegangen, also 60 Volt Spannung über ein einzelnes Photovoltaikmodul mit 60 Zellen. Sollte der Netzbetreiber, an den die Photovoltaikanlage angeschlossen ist, diese aus welchen Gründen auch immer vom Netz nehmen (e.g. Kurzschluss in dem Einspeisekabel) springt die Spannung auf die genannten 720 Volt, was für die Module und die Anlage unkritisch ist.

Auf der anderen Seite wäre es wünschenswert, die Photovoltaik-Module und auch den Wechselrichter im Normalbetrieb mit einer höheren Spannung als 480 - 510 Volt, idealerweise mit der zulässigen Höchstspannung von 1000 Volt zu betreiben. Dieses ist aber nicht möglich, da dann im Leerlauffall eine Spannung von ca. 1500 Volt zur Zerstörung der Photovoltaik-Module und des Wechselrichters und der Anlage führen würde.

Aus der US 2008/147335 A1 ist ein Photovoltaikgenerator mit den Merkmalen des Oberbegriffs von Anspruch 1 bekannt. Die Schrift behandelt die Überwachung und Steuerung des PV-Generators anhand einer Vielzahl von ermittelten Betriebswerten von einzelnen Generatoreinheiten.

Aus der DE 10 2006 060 815 A1 ist ein Photovoltaikgenerator bekannt, bei dem jedes verbaute PV-Modul mit einem eigenen zugeordneten Kurzschlussschalter versehen ist. Die Schalter werden über ein Freigabesignal aktiviert. Ziel ist es, z. B. in einem detektierten Brandbefall den PV-Generator spannungsfrei zu schalten, oder bei Revisionsarbeiten eine Prüfung von einzelnen Modulen zu ermöglichen.

Zum Betrieb der Photovoltaikanlage mit einer höheren Betriebsspannung ist es aus der DE 3041078 bekannt, einen Kurzschlussschalter einzusetzen, der einen Teil der Module im Falle einer auftretenden Überspannung kurzschließt.

Diese Maßnahme ist jedoch bei einer großen Anlage mit Hunderten von Feldern mit einem hohen Verdrahtungsaufwand und Schalteraufwand verbunden. Die Felder liegen zum Teil einige Hundert Meter auseinander und es entsteht ein Mehrbedarf an mehreren Kilometern Kabel, die verlegt und angeschlossen werden müssen.

Der Erfindung liegt daher die Aufgabe zugrunde, eine Photovoltaikgroßanlage mit geringem Leitungsaufwand vor Überspannung bei fehlender Wechselstromeinspeisung zu schützen.

Diese Aufgabe wird erfindungsgemäß dadurch gelöst, dass ein Teil der Photovoltaikmodule (M) eines Strangs (S) über einen Kurzschlussschalter (15) kurzschließbar ist, dessen Aktivierung bei Überschreitung eines vorgegebenen Spannungswertes über dem Strang (5) erfolgt, und dass nur bei einem Teil der Felder der Kurzschlussschalter (15) vorgesehen ist. So brauchen nur die bezüglich zum Wechselrichter und der Steuerung nahegelegenen Felder mit dem Kurzschlussschalter versehen werden, was zu einer erheblichen Kabelersparnis führt. Durch die Reduktion der Spannung an einem oder mehreren Feldern wird das Potential der anderen in der Parallelschaltung befindlicher Felder heruntergezogen auf einen für den Wechselrichter verkraftbaren Spannungswert.

Weitere Vorteile und Einzelheiten der Erfindung ergeben sich aus der Beschreibung eines Ausführungsbeispiels anhand der Figuren. Es zeigen:
- Figur 1: eine schematische Darstellung eines konventionellen Photovoltaikgenerators mit acht Modulen pro Strang;
- Figur 1a: ein bekanntes Modul mit 60 Photovoltaikzellen;
- Figur 2: eine schematische Darstellung eines Strangs mit 16 Modulen;
- Figur 3: ein Diagramm zur Arbeitsweise eines MPP-Reglers;

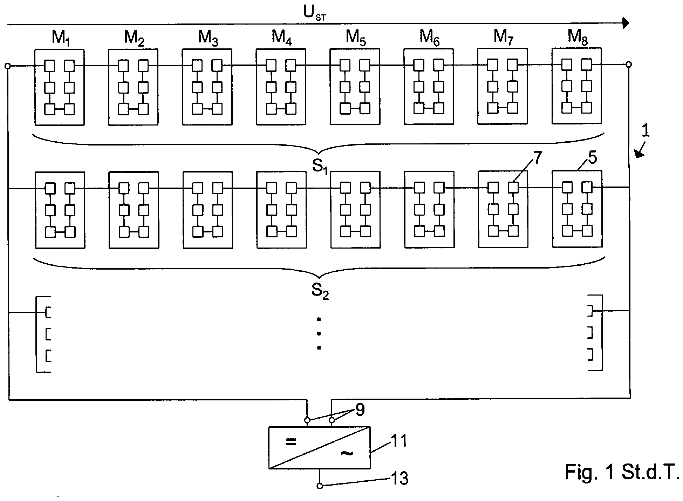

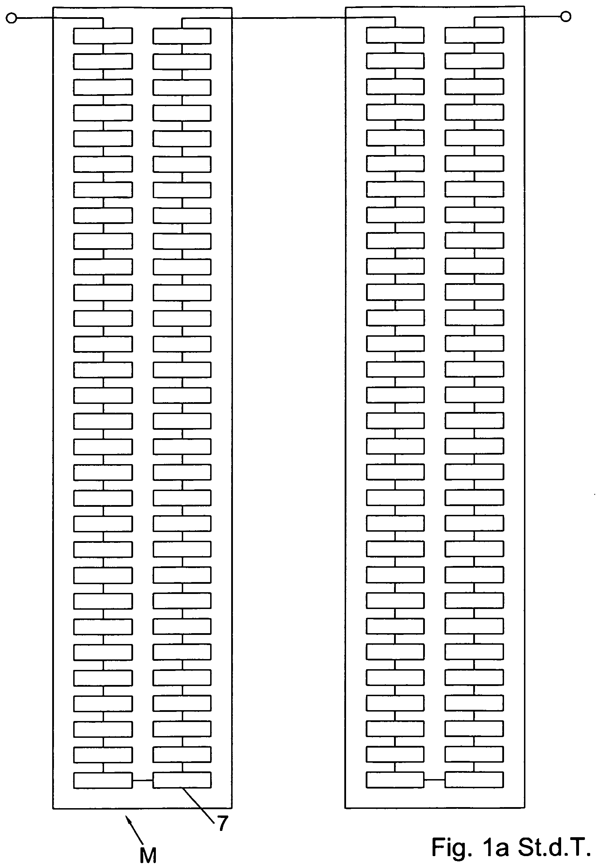

In der Figur 1 ist ein handelsüblicher Photovoltaikgenerator 1 dargestellt, der aus einer Anzahl von parallel geschalteter Stränge S besteht, die wiederum eine Anzahl, im gezeigten Ausführungsbeispiel acht, in Reihe geschalteter Photovoltaikmodulen M bestehen. Jedes Photovoltaikmodul M weist in Reihe geschaltete Photovoltaikzellen 7 auf, wie es aus der Figur 1 ersichtlich ist. Üblich für ein Photovoltaikmodul M ist zum Beispiel der Einsatz von 60 Zellen zu je 1,5 Volt Leerlaufspannung oder auch 130 Zellen zu jeweils ca. 0,69 Volt. In beiden Fällen ergibt sich eine im Leerlauf auftretende Spannung von ca. 90 Volt über das Modul M, bei acht Modulen also ca. 720 Volt. Im Betrieb sinkt diese Spannung auf ca. 60 bis 65 Volt, sodass sich eine Strangspannung Ust von 480 bis 510 Volt ergibt.

Die parallel geschalteten Stränge S sind an ihren Enden an den Eingang 9 eines Wechselrichters 11 gelegt, dessen Ausgang 13 den erzeugten Strom z.B. in ein Netz einspeist.

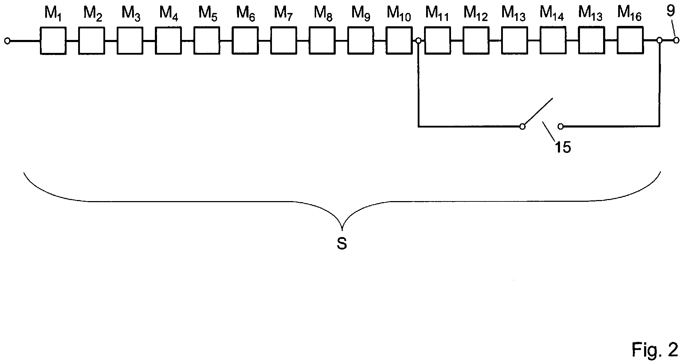

Die Leerlaufspannung von 720 Volt liegt deutlich unterhalb der zurzeit zulässigen Grenze von 1000 Volt, die die Hersteller von Photovoltaikmodulen für ihr Produkt als obere Grenze angeben. Im Betrieb wird ein entsprechend noch größerer Sicherheitsabstand zu den 1000 Volt erreicht. Bei den bekannten Anlagen dieser Art wäre es wünschenswert, die zulässige Höchstspannung von 1000 Volt voll auszunutzen, um die Querschnitte der zu verlegenden Kabel klein zu halten. Hierzu dient die Photovoltaikanlage 1 nach der Figur 2. Dort ist ein einziger Strang S mit diesmal 16 Photovoltaikmodulen M gezeigt, der zusammen mit anderen nicht gezeigten Strängen parallel geschaltet ist und zu dem Eingang 9 des Wechselrichters 11 geführt ist. Im gezeigten Ausführungsbeispiel weist der Strang S die doppelte Anzahl an Modulen M auf also 16 Stück, von denen jedes entsprechend der Figur 1 a aufgebaut ist. Daraus ergibt sich eine unzulässig hohe Leerlaufspannung von 1440 Volt über den Strang S, aber eine zulässig hohe Betriebsspannung von 960 bis 1020 Volt, die an einem der Module M und dem Eingang 9 des Wechselrichters 11 anliegt. Eine Überschreitung um 20 Volt über die Zulässigkeit wird dabei als tolerabel angesehen.

Um bei einer Trennung vom Netz eine Zerstörung von Wechselrichter 11 und Modul M zu verhindern, ist ein Kurzschlussschalter 15 vorgesehen. Der Schalter 15 ist so positioniert, dass er zwischen einem Zehntel, insbesondere zwischen einem Viertel und der Hälfte der Module M kurzschließt. Die Ansteuerung des Schalters 15 wird von einem Grenzwertdetektor (nicht gezeigt) vorgenommen, der ermittelt, wenn die Spannung über den Strang S den vorgebbaren Wert, hier im Beispiel 1000 Volt, übersteigt.

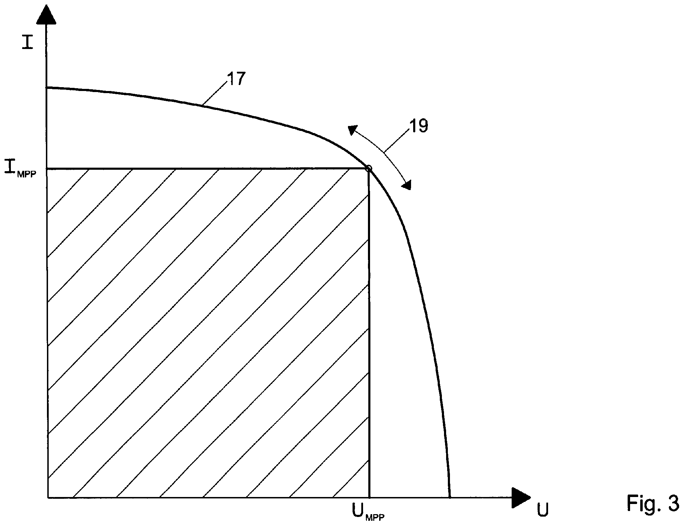

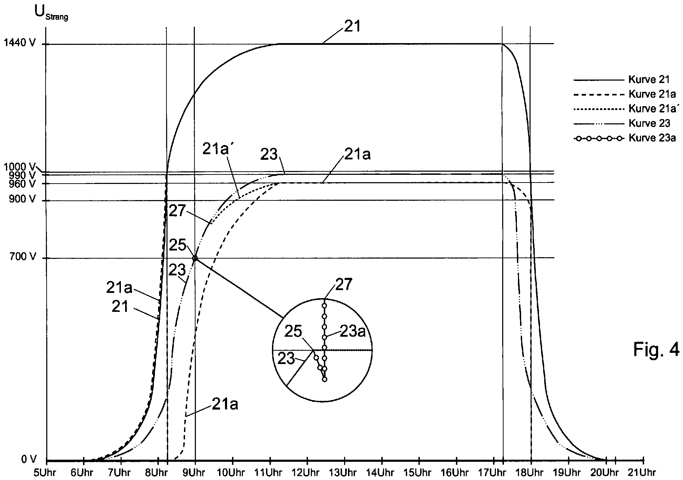

Im Folgenden wird anhand der Figuren 3 und 4 ein weiterer wesentlicher Vorteil im täglichen Betrieb des erfindungsgemäßen Photovoltaikgenerators 1 erläutert. In der Figur 3 ist der Verlauf des erzeugten Stroms I über der einhergehenden Spannung U einer typischen Photovoltaikanlage 1 dargestellt. Diese Strom/Spannungskurve 17 wird mittels eines MPP (Maximum Power Point) Reglers auf einen Punkt gehalten, an dem eine maximale Leistung vorliegt. Diese maximale Leistung ist das Produkt aus dem IMPP und der UMPP und entspricht dem schraffiert markiertem Feld, das in diesem Fall eine maximale Fläche einnimmt. Der MPP-Regler regelt auf der Kurve 17 entlang des Doppelpfeils 19 und hat das Bestreben, die Photovoltaikanlage auf den MPP hinzuführen. Dieser Punkt ändert sich ständig je nach Sonnenstand, Bewölkung, Luftverschmutzung und dergleichen.

Aufgrund der hohen Anzahl an eingebauten Modulen M in einen Strang S könnte der MPP-Regler den zulässigen Höchstwert der Betriebsspannung übersteigen. Dieses wird verhindert, indem der Regelalgorithmus um die Bedingung erweitert wird, dass der vorgegeben Spannungswert (hier im Beispiel 1000 Volt) nicht überschritten werden darf. Diese Bedingung hat Vorrang vor dem Erzielen eines optimalen Leistungspunktes MPP. Vorteilhafterweise wird an dem MPP-Regler ein Ausgang vorgesehen, der auf ein Schließen des Schalters 15 hinwirkt, falls diese Bedingung aus welchen Gründen auch immer verletzt wird.

In der Figur 4 ist ein typischer Verlauf der an dem Strang S anliegenden Spannung bei dem morgendlichen Anfahren der Anlage 1 dargestellt. Die Kurve 21 zeigt dabei den fiktiven Verlauf der Spannung über die Tageszeit im Leerlauffall und die Kurve 21a im Betriebsfall mit zugeschaltetem Wechselrichter 11 nachdem dieser bei Erreichen der maximal zulässigen Strangspannung von 1000 Volt zugeschaltet wurde, um die erzeugten Energie in das Netz über die Ausgangsklemmen 13 einzuspeisen. Dabei folgt die Kurve 21a bis zum Zuschaltvorgang des Wechselrichters der Leerlaufkurve 21. Die Kurve 21 strebt bei der beispielhaften Verwendung von 16 Modulen M pro Strang S der Leerlaufspannung von ca. 1440 Volt entgegen. Entsprechend läuft die Kurve 21a unter Last auf die Betriebsspannung von 960 Volt (entsprechend 16 mal 60 Volt) zu. In dem Diagramm der Figur 4 ist außerdem noch eine weitere, gepunktetgestrichelt ausgeführte Kurve 23 gezeigt, die dem Leerlauf- Spannungsverlauf bei geschlossenem Schalter 15 zeigt, also bei den im Beispiel überbrückten fünf Modulen M. Diese Kurve 23 läuft bis zum Zeitpunkt, an dem der Wechselrichter 11 zugeschaltet wird, auf die Leerlaufspannung von den verbleibenden elf in Reihe geschalteten, aktiven Modulen M zu, also auf ca. 990 Volt (entsprechend 11 mal 90 Volt.

Beim morgendlichen Anfahren ohne kurzgeschlossene Module M ergäbe sich der Verlauf nach Kurve 21 und die 1000 Volt oberer zulässiger Spannungswert wären um ca. 8.15 Uhr erreicht. Da die minimal erforderliche Leistung von 1 KW zum Zuschalten des Wechselrichters 11 noch nicht erreicht ist, bricht die Spannung zusammen und muss von Null beginnend neu aufgebaut werden wie es der Verlauf der Kurve 21a ab 8.15 Uhr darstellt. Die minimal erforderliche Leistung ist von dem verwendeten Wechselrichter 11 abhängig und kann bei einer 2,5 Megawatt Großanlage ca. 15 KW betragen. Ebenso ist eine gewisse Leerlaufspannung erforderlich, damit ein stabiles Ankoppeln des Wechselrichters 11 an das Netz erfolgen kann. Bei dem in Figur 4 gezeigten Ausführungsbeispiel wird bei einem Vorliegen von 11 Modulen M das Erreichen der Zuschaltkriterien bei einer Strangspannung Ust von 700 Volt angenommen.

Hier kommt der Kurzschlussschalter 15 zum Einsatz, der bei Beginn des Hochfahrens der Anlage eingeschaltet also geschlossen ist. Die Photovoltaikanlage arbeitet mit elf Modulen M pro Strang S auf der gepunktetgestrichelten Linie 23 und erreicht gegen 9.00 Uhr einen Leistungspunkt 25, an dem die erforderliche Mindestleistung von 1 KW zum stabilen Zuschalten auf das Netz erreicht ist. Zu diesem Zeitpunkt beträgt die Strangspannung Ust 700 Volt. Ab diesem Zeitpunkt wird der Schalter 15 geöffnet, was ein kurzzeitiges Absinken der Spannung zur Folge hat, was durch den in der Lupendarstellung eingekreisten Zacken symbolisiert ist, da der MPP-Regler diese Situation nicht sofort ausgleichen kann. In der Realität ist der Zacken nur einige Sekunden lang. Der MPP-Regler setzt mit seinem Regelverhalten ein und führt die Spannung Ust in kürzester Zeit der Kurve 23a zu einem Punkt 27 auf einer Betriebsspannungskurve 21a' für den vollen Strang S mit allen sechzehn Modulen M. Die Kurve 21a' ist mit kurzen Strichen dargestellt und verläuft von der Kurve 21a parallel nach links versetzt ab von dem Punkt 27. Von dort aus strebt die Kurve 21a' im weiteren Verlauf des Tages mit höher stehender Sonne dem maximalen Wert der Betriebsspannung Ust von 960 Volt entgegen. Im Ergebnis wird eine frühere Leistungseinspeisung in das Netz erzielt, als es ohne den Schalter 15 möglich wäre. Im gezeigten Beispiel setzt die Netzeinspeisung um 8.45 Uhr ein, wohingegen sie beim Betrieb der Photovoltaik-Anlage entlang der Kurve erst um 9.20 Uhr einsetzen würde.

Abends beim Herunterfahren der Anlage 1 wiederholt sich der Vorgang in umgekehrter Reihenfolge. Die Erfindung bietet also neben den günstigeren Kabelquerschnitten noch den weiteren Vorteil eines effektiveren Anfahrverhaltens im Vergleich zu Anlagen ohne Kurzschlussschalter 15.

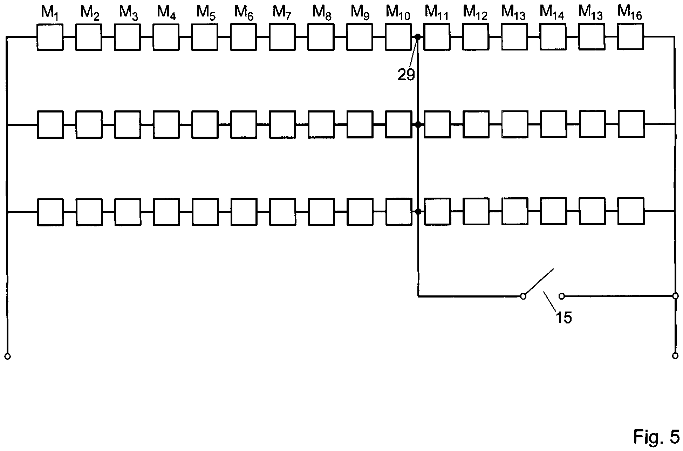

In der Figur 5 ist gezeigt, wie sechs der 16 Module M gemeinsam bei allen Strängen S der Photovoltaik-Anlage kurzschließbar sind. Dazu dient die nach dem zehnten Modul M liegenden Leitungspunkte 29 jeweils miteinander verbunden und dann zum Kurzschlussschalter 15 geführt.

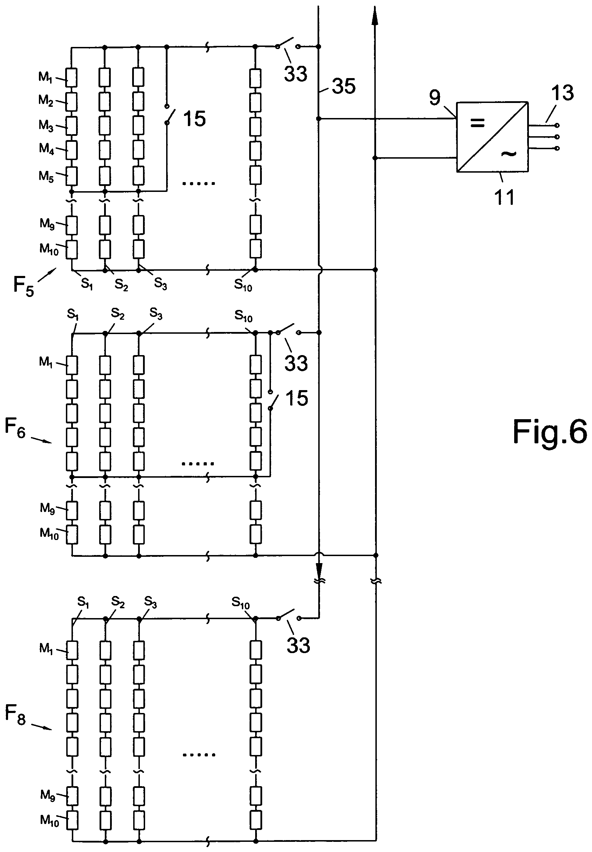

In der Figur 6 ist der Aufbau eines erfindungsgemäßen Photovoltaikgenerators gezeigt, bei dem p = 8 Felder F₁ bis F₈ zu jeweils n = 10 Strängen S₁ bis S₁₀ vorgesehen sind. Das erste Feld F₅, vorzugsweise das, welches dem Wechselrichter 11 am nächsten liegt, ist mit drei Strängen S nach der Figur 5 ausgestattet, bei dem fünf Module M über den Kurzschlussschalter 15 kurzschließbar sind. Beim benachbarten, zweiten Feld F₆ sind alle Stränge S mit dem Kurzschlussschalter 15 versehen. Im Falle eines Kurzschlusses auf der Wechselspannungsseite 13 werden
der oder die Kurzschlussschalter 15 geschlossen und, wenn keine ausreichende Spannungsbegrenzung an der Eingangsseite des Wechselrichters 11 zu verzeichnen ist, werden noch Trennschalter 33 geöffnet, die die Felder F an eine Sammelleitung 35 anschließen, die zu dem Eingang 9 des Wechselrichter 11 führt. Es werden so viele Felder F mit dem Kurzschlussschalter 15 versehen, wie mögliche Ausgleichsströme zwischen den Feldern von den Leitungen und der Sammelleitung 35 toleriert werden können. Sollte eine weitere Reduktion der Spannung am Wechselrichtereingang 9 nötig sein, weil das genannte Herunterziehen des Potentials nicht ausreicht, um auf eine ungefährliche Eingangsspannung am Wechselrichter 11 zu gelangen, so wäre die Anzahl der Module M pro Strang S zu verringern, z.B. von 16 auf 12.

### Bezugszeichenliste

- S: Strang
- M: Photovoltaikmodul
- F: Feld
- 1: Photovoltaikgenerator
- 7: Photovoltaikzelle
- 9: Eingang Wechselrichter
- 11: Wechselrichter
- 13: Ausgang Wechselrichter
- 15: Kurzschussschalter
- 17: Strom/Spannungskurve
- 19: Doppelpfeil
- 21: Leerlaufkurve 16 Module, durchgezogene Linie
- 21a: Lastkurve 16 Module, lang-gestrichelte Linie
- 21a': Lastkurve ab Schalteröffnung an Punkt 27 entsprechend dann 16 Module
- 23: Leerlauf-Spannungsverlauf bis Schalteröffnung entsprechend elf Module, gestrichelt / gepunktete Linie bis Zuschaltpunkt 25
- 23a: MPP Regelkurve im Sekundenbereich zwischen Schalteröffnung und Erreichen der Lastkurve 21a', hohl-gepunktete Linie
- 25: Leistungspunkt
- 27: Spannungspunkt
- 29: Leitungspunkt
- 33: Trennschalter
- 35: Sammelleitung

## Patentansprüche

1. Photovoltaikgenerator (1) mit einer Vielzahl von parallel geschalteten Feldern, wobei jedes Feld aus mehreren parallel geschalteten Strängen (S) von in Reihe geschalteten Photovoltaikmodulen (M) besteht, **dadurch gekennzeichnet, dass** ein Teil der Photovoltaikmodule (M) eines Strangs (S) über einen Kurzschlussschalter (15) kurzschließbar ist, dessen Aktivierung bei Überschreitung eines vorgegebenen Spannungswertes über dem Strang (5) erfolgt, und dass nur bei einem Teil der Felder der Kurzschlussschalter (15) vorgesehen ist.

2. Photovoltaikgenerator nach Anspruch 1, **dadurch gekennzeichnet, dass** nur ein einziges Feld mit dem Kurzschlussschalter ausgerüstet ist.

3. Photovoltaikgenerator nach Anspruch 1 oder 2, **dadurch gekennzeichnet, dass** die Felder über einen Trennschalter aus der Parallelschaltung herausnehmbar sind.

4. Photovoltaikgenerator nach Anspruch 1 oder 2, **dadurch gekennzeichnet, dass** der Kurzschlussschalter ein gemeinsamer Schalter (15) zum Kurzschließen der Photovoltaikmodule (M) mehrerer Stränge (S) ist und der Kurzschlussschalter (15) den Stromfluss zu den mehreren Strängen (S) unterbricht oder freigibt.

5. Photovoltaikgenerator nach einem der Ansprüche 1 bis 4, **dadurch gekennzeichnet, dass** der Kurzschlussschalter (15) so angeordnet ist, dass die Hälfte der Photovoltaikmodule (M) kurzgeschlossen wird.

6. Photovoltaikgenerator nach einem der Ansprüche 1 bis 5, **dadurch gekennzeichnet, dass** wenigstens zwei Stränge (S) mit je einem Kurzschlussschalter (15) ausgestattet sind, die unterschiedlich viele Module (M) in den Strängen (S) kurzschließen.

7. Photovoltaikgenerator nach einem der Ansprüche 1 bis 6, **dadurch gekennzeichnet, dass** das Signal zur Aktivierung des Kurzschlussschalters (15) von einem Ausgang eines Reglers für die maximale Leistung (MPP-Regler) genommen wird.

8. Photovoltaikgenerator nach einem der Ansprüche 1 bis 7, **dadurch gekennzeichnet, dass** der vorgegebene Spannungswert im Bereich von 900 Volt bis 1200 Volt liegt.

9. Photovoltaikgenerator nach einem der Ansprüche 1 bis 8, **dadurch gekennzeichnet, dass** ein Viertel bis die Hälfte aller Photovoltaikmodule (M) kurzschließbar ist.

10. Photovoltaikgenerator nach einem der Ansprüche 1 bis 9, **dadurch gekennzeichnet, dass** mehrere Stränge (S) hinter derselben Anzahl an Photovoltaikmodulen (M) miteinander verbunden sind und der Schalter (15) alle zwischen dem Zehntel und der Hälfte liegenden Photovoltaikmodule (M) aller mehreren Stränge gleichzeitig kurzschließt. (Figur 5)

## Claims

1. A photovoltaic generator (1) with a plurality of parallel-connected fields, wherein each field comprises a plurality of parallel-connected strings (S) of series-connected photovoltaic modules (M), **characterised in that** a portion of the photovoltaic modules (M) of a string (S) are short-circuitable via a short-circuit switch (15), the activation of which occurs when a predetermined voltage value on the string (5) is exceeded, and that only a portion of the fields is provided with the short-circuit switch (15).

2. The photovoltaic generator according to claim 1, **characterised in that** only a single field is equipped with the short-circuit switch.

3. The photovoltaic generator according to claim 1 or 2, **characterised in that** the fields are removable from the parallel connection via a disconnect switch.

4. The photovoltaic generator according to claim 1 or 2, **characterised in that** the short-circuit switch is a common switch (15) for short-circuiting the photovoltaic modules (M) of a plurality of strings (S) and the short-circuit switch (15) interrupts or releases the current flow to the plurality of strings (S).

5. The photovoltaic generator according to any one of claims 1 through 4, **characterised in that** the short-circuit switch (15) is arranged such that half of the photovoltaic modules (M) are short-circuited.

6. The photovoltaic generator according to one of claims 1 through 5, **characterised in that** at least two strings (S) are each equipped with a short-circuit switch (15), which short-circuits various numbers of modules (M) in the strings (S).

7. The photovoltaic generator according to any one of claims 1 through 6, **characterised in that** the signal for activating the short-circuit switch (15) is taken from an output from a maximum power controller (MPP controller).

8. The photovoltaic generator according to any one of claims 1 through 7, **characterised in that** the predetermined voltage value is in the range of 900 volts to 1200 volts.

9. The photovoltaic generator according to any one of claims 1 through 8, **characterised in that** one quarter to half of all photovoltaic modules (M) are short-circuited.

10. The photovoltaic generator according to one of claims 1 through 9, **characterised in that** a plurality of strings (S) behind the same number of photovoltaic modules (M) are connected to one another and the switch (15) simultaneously short circuits all of the photovoltaic modules (M) located between one tenth and half of all the plurality of strings. (Figure 5)

## Revendications

1. Générateur photovoltaïque (1) ayant une pluralité de champs montés en parallèle, chaque champ comprenant plusieurs strings (S) montés en parallèle constitués de modules photovoltaïques (M) montés en série, **caractérisé en ce qu'**une partie des modules photovoltaïques (M) d'un string (S) peut être court-circuitée au moyen d'un coupe-circuit (15) qui est activé lors du dépassement d'une valeur de tension prédéterminée dans le string (5) et **en ce que** le coupe-circuit (15) est prévu uniquement pour une partie des champs.

2. Générateur photovoltaïque selon la revendication 1, **caractérisé en ce qu'**un seul champ est équipé du coupe-circuit.

3. Générateur photovoltaïque selon la revendication 1 ou 2, **caractérisé en ce que** les champs peuvent être déconnectés du montage en parallèle au moyen d'un sectionneur.

4. Générateur photovoltaïque selon la revendication 1 ou 2, **caractérisé en ce que** le coupe-circuit est un interrupteur (15) commun pour court-circuiter les modules photovoltaïques (M) de plusieurs strings (S) et le coupe-circuit (15) interrompt ou permet la circulation du courant vers les différents strings (S).

5. Générateur photovoltaïque selon l'une des revendications 1 à 4, **caractérisé en ce que** le coupe-circuit (15) est agencé de manière à court-circuiter la moitié des modules photovoltaïques (M).

6. Générateur photovoltaïque selon l'une des revendications 1 à 5, **caractérisé en ce qu'**au moins deux strings (S) sont équipés chacun d'un coupe-circuit (15) court-circuitant différemment une bonne partie des modules (M) dans les strings (S).

7. Générateur photovoltaïque selon l'une des revendications 1 à 6, **caractérisé en ce que** le signal pour activer le coupe-circuit (15) est pris au niveau d'une sortie d'un régulateur pour la puissance maximale (régulateur MPP).

8. Générateur photovoltaïque selon l'une des revendications 1 à 7, **caractérisé en ce que** la valeur de tension prédéterminée se situe dans la plage de 900 volts à 1200 volts.

9. Générateur photovoltaïque selon l'une des revendications 1 à 8, **caractérisé en ce qu'**il est possible de court-circuiter un quart à la moitié de tous les modules photovoltaïques (M).

10. Générateur photovoltaïque selon l'une des revendications 1 à 9, caractérisé en ce plusieurs strings (S) ayant le même nombre de modules photovoltaïques (M) sont raccordés les uns aux autres et en ce que l'interrupteur (15) court-circuite en même temps entre le dixième et la moitié des modules photovoltaïques (M) des différents strings. (Figure 5)
